(19) Europäisches Patentamt
European Patent Office
Office européen des brevets

(11) **EP 1 876 455 A1**

(12) **EUROPÄISCHE PATENTANMELDUNG**

(43) Veröffentlichungstag:
 **09.01.2008 Patentblatt 2008/02**

(51) Int Cl.:
 *G01R 31/02* [(2006.01)]   *G01R 27/18* [(2006.01)]

(21) Anmeldenummer: **07012028.2**

(22) Anmeldetag: **20.06.2007**

(84) Benannte Vertragsstaaten:
 **AT BE BG CH CY CZ DE DK EE ES FI FR GB GR HU IE IS IT LI LT LU LV MC MT NL PL PT RO SE SI SK TR**
 Benannte Erstreckungsstaaten:
 **AL BA HR MK YU**

(30) Priorität: **08.07.2006 DE 102006031663**

(71) Anmelder: **SEMIKRON Elektronik GmbH & Co. KG**
 **90431 Nürnberg (DE)**

(72) Erfinder: **Backhaus, Klaus, Dr.**
 **90768 Fürth (DE)**

(54) **Verfahren zur Messung des Isolationswiderstands in einem IT-Netz**

(57)   Die Erfindung beschreibt ein Verfahren zur Messung des Isolationswiderstands in einem IT-Netz. Diese weist typischerweise einen Gleichspannungszwischenkreis und mindestens einen selbstgeführten Stromrichter mit mindestens einem ersten und einem zweiten Leistungsschalter auf. Ebenso ist eine Messanordnung zur Messung der Zwischenkreisspannung gegen Grundpotential bestehend aus einem Spannungsteiler und zwei zugeordneten Potentialmesseinrichtungen Teil des IT-Netzes. Das Verfahren weist eine offline- und eine online-Messung auf, wobei während der offline- Messung alle ersten oder zweiten Leistungsschalter geschlossen sind und die Potentiale Up bzw. Um sowie die Zwischenkreisspannung gemessen werden und daraus der Isolationswiderstand Rf bestimmt wird. Während der online- Messung werden die beiden Potentiale Up und Um gemessen und der zeitliche Verlauf der Messungen geeignet bewertet.

Fig. 3

**EP 1 876 455 A1**

**Beschreibung**

Die Erfindung beschreibt ein Messverfahren zur Bestimmung des Isolationswiderstands in einem abgeschlossenen, vollständig isolierten Stromnetz, einem sog. IT-Netz. Derartige IT-Netze finden beispielhaft in Fahrzeugen Anwendung.

Unter einem IT-Netz wird allgemein eine Netzform der Elektrotechnik verstanden bei der die speisende Stromquelle nicht wie üblich geerdet ist. Somit wird bei einem ersten Fehlerfall, beispielhaft einem Isolationsfehler, kein geschlossener Stromkreis aufgebaut und es kann hierbei auch keine gefährliche Körperdurchströmung stattfinden. Gleichermaßen muss bei einem ersten Fehler der Betrieb des IT-Netzes nicht eingestellt werden, was eine höhere Ausfallsicherheit bewirkt. Nachteilig hierbei ist allerdings, dass dieser erste Fehlerfall auch nicht erkannt wird solange die Isolation gegen Erde nicht durch ein Isolationsüberwachungsgerät gemessen wird. Ein IT-Netz gemäß dem Stand der Technik ist Ausgangspunkt dieser Erfindung und weist mindestens eine Stromquelle, vorzugsweise einen Generator, mindestens einen Gleichrichter, einen Zwischenkreis mit mindestens einem Kondensator, sowie mindestens einen Stromrichter sowie eine Messanordnung für die Zwischenkreisspannung auf.

Auf Grund der oben beschriebenen Eigenschaften von IT-Netzen ist eine Kontrolle der Isolation zu Betriebsbeginn sowie auch während des Betriebs besonders bevorzugt. Die EP 0 751 396 B1 beschreibt hierzu ein Verfahren, welches einen erheblichen zusätzlichen schaltungstechnischen Aufwand über die den im IT- Netz vorhandenen hinaus erfordert.

Grundsätzlich bekannte Fehlerfälle in einem IT-Netz sind verschiedenartige Veränderungen des Isolationswiderstands, die alle durch eine geeignete Überwachung sicher erkannt werden müssen. Zu diesen Fehlerfällen zählt beispielhaft die Alterung der Isolation, die eine zeitlich langsame häufig sogar über alle Phasen symmetrische Änderung des Isolationswiderstands nach sich zieht. Ein ebenso bekannter Fehlerfall ist beispielhaft begründet in der Beschädigung einer Isolation, welche eine zeitlich schneller verlaufende Änderung des Isolationswiderstands meist nur einer Phase bewirkt.

Der Erfindung liegt die Aufgabe zugrunde, ein Verfahren zur Messung des Isolationswiderstands in einem IT-Netz vorzustellen, wobei die Messung symmetrische Änderungen ebenso wie unsymmetrische Änderungen sicher erkennen soll und wobei der notwendige schaltungstechnische Zusatzaufwand möglichst gering sein soll.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem IT-Netz, vorzugsweise mit einem Generator oder einer anderen Stromquelle, mit einem durch diese Stromquelle gespeisten Gleichspannungszwischenkreis und mindestens einem selbstgeführten Stromrichter. Dieser Stromrichter weist mindestens einen ersten und einen zweiten Leistungsschalter und eine Mittelanzapfung auf.

Weiterhin weist das IT-Netz eine Messanordnung zur Messung der Zwischenkreisspannung auf. Diese Messanordnung weist vorzugsweise einen symmetrisch ausgebildeten Spannungsteiler und zwei zugeordnete Messeinrichtungen zur Potentialmessung der beiden Zwischenkreispotentiale gegen Grundpotential auf.

Das erfindungsgemäße Verfahren zur Messung des Isolationswiderstands besteht aus einer "offline-" sowie einer "online-" Messung. Während der offline- Messung beispielhaft zu Betriebsbeginn sind alle ersten oder zweiten Leistungsschalter aller Stromrichter geschlossen. Es werden in diesem Schaltzustand die beiden Potentiale des Zwischenkreises gemessen. Bei einer Unsymmetrie der gemessenen Potentiale sowie in Kenntnis der Messeinrichtung, im speziellen Fall der Messwiderstände, wird ein Isolationsfehler sicher erkannt. Eine Lokalisierung dieses Fehlers ist durch selektives Öffnen der verschiedenen Leistungsschalter möglich. Ebenso ist die Prüfung der Funktion der Messanordnung selbst mittels dieser offline- Messung möglich. Wenn alle Schalter geöffnet sind müssen die beiden Potentiale des Zwischenkreises betragsmäßig gleich sein. Bei Schließen eines Schalters muss der Messwert einen bekannten zeitlichen Verlauf einnehmen. Vorteilhafterweise wird der durch die vorhandene parasitäre Lastkapazität resultierende Einschwingvorgang der Potentialmessungen zur Funktionsüberprüfung der Isolationsmesseinrichtung verwendet wird, wodurch kein zusätzlicher Hardwareaufwand für eine derartige Simulation eines Isolationsfehlers erforderlich ist.

Während der online- Messung im Betrieb des IT-Netzes werden wiederum die beiden Potentiale gemessen und der zeitliche Verlauf dieser Messung bewertet. In einer ersten Ausgestaltung werden hier die beiden gemessenen Potentiale summiert, anschließend diese Summe Fourier transformiert und die Änderung des Frequenzspektrums in ihrem zeitlichen Verlauf bewertet.

In einer zweiten Ausgestaltung der online-Messung werden die beiden gemessenen Potentiale summiert, der Betrag dieser Summe geeignet gemittelt und dieser Mittelwert in seinem zeitlichen Verlauf bewertet.

Die erfinderische Lösung wird an Hand der Ausführungsbeispiele und der Fig. 1 bis 6 weiter erläutert.

Fig. 1 zeigt ein IT-Netz gemäß dem Stand der Technik.

Fig. 2 zeigt einen Wechselrichter und einen Motor in einem IT-Netz mit einem ersten beispielhaften Isolationsfehler.

Fig. 3 zeigt einen Generator mit Gleichrichter und eine Messeinrichtungen in einem IT-Netz mit weiteren beispielhaften Isolationsfehlern.

Fig. 4 zeigt Potentialverläufe bei einer online-Messung ohne Isolationsfehler.

Fig. 5 zeigt den zeitlichen Verlauf des Betrags der Summe der Messwerte einer online-Messung mit einem ersten Isolationsfehler.

Fig. 6 zeigt den zeitlichen Verlauf des Betrags der Summe der Messwerte einer online-Messung mit einem zweiten Isolationsfehler.

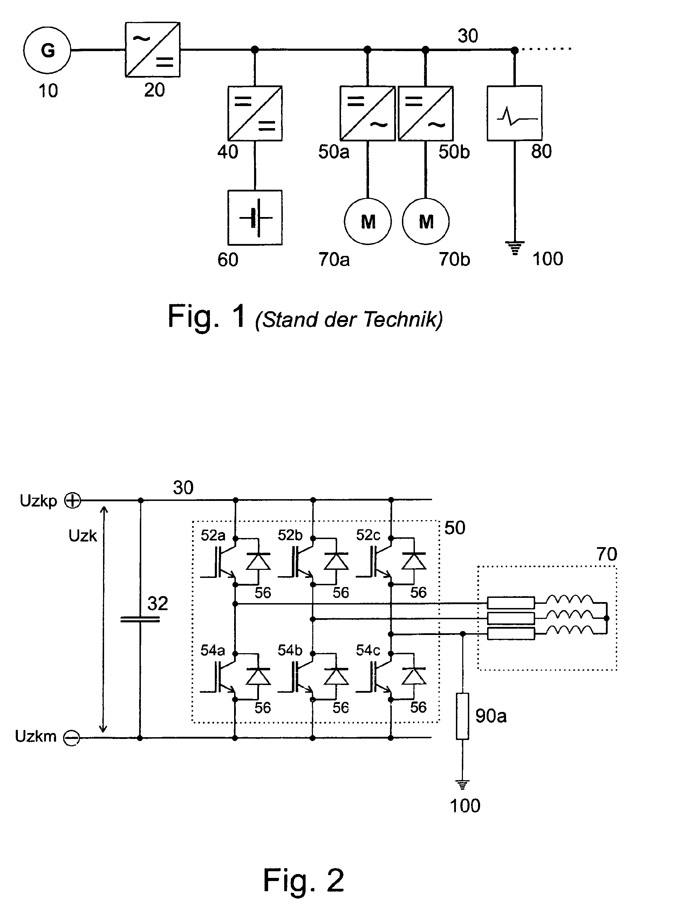

Fig. 1 zeigt ein IT-Netz gemäß dem Stand der Technik, wie es beispielhaft in einem Straßenfahrzeug Anwendung finden kann. Dieses IT- Netz weist einen Generator (10) zur Stromerzeugung auf, dem ein aktiver Gleichrichter (20) zur Versorgung des Gleichspannungszwischenkreises (30) nachgeschaltet ist. Vorteilhafterweise weist dieser Zwischenkreis (30) noch mindestens einen Kondensator (32) zur Energiespeicherung auf. An den Zwischenkreis (30) ist ein Gleichspannungsumrichter (40) mit einer Batterie (60) angeschlossen. Ebenso sind hier zwei Wechselrichter (50 a/b) mit je einem Motor (70 a/b) an den Zwischenkreis (30) angeschlossen. Zur Messung der Zwischenkreisspannung ist noch eine Messeinrichtung (80) angeschlossen.

Fig. 2 zeigt einen Wechselrichter (50) und einen Motor (70) in einem IT-Netz mit einem ersten beispielhaften Isolationsfehler (90a). Hierbei speist der Gleichspannungszwischenkreis (30) einen selbstgeführten Wechselrichter (50), wobei dieser drei erste Leistungsschalter (52 a/b/c) aufweist. Jeder Leistungsschalter besteht aus einer antiparallelen Anordnung von mindestens einem IGBT (insulated gate bipolar transistor) mit mindestens einer Freilaufdiode (56). Ebenso weist der Wechselrichter drei zweite ebenso mit IGBTs und Freilaufdioden (56) ausgebildete Leistungsschalter (54 a/b/c) auf. Die drei ersten (52 a/b/c) und zweiten (54 a/b/c) Leistungsschalter bilden die Brückenschaltung des Dreiphasen- Wechselrichters (50) aus. Am Ausgang der drei Phasen ist der Motor (70) angeordnet. Dessen Impedanzen sind in Form einer Reihenschaltung eines ohmschen Widerstands und einer Induktivität je Phase dargestellt.

Der Widerstand (90a) symbolisiert hier einen ersten Isolationsfehler. Der Wert (Rf) dieses Widerstands (90a) wird mittels des erfindungsgemäßen Verfahrens ermittelt.

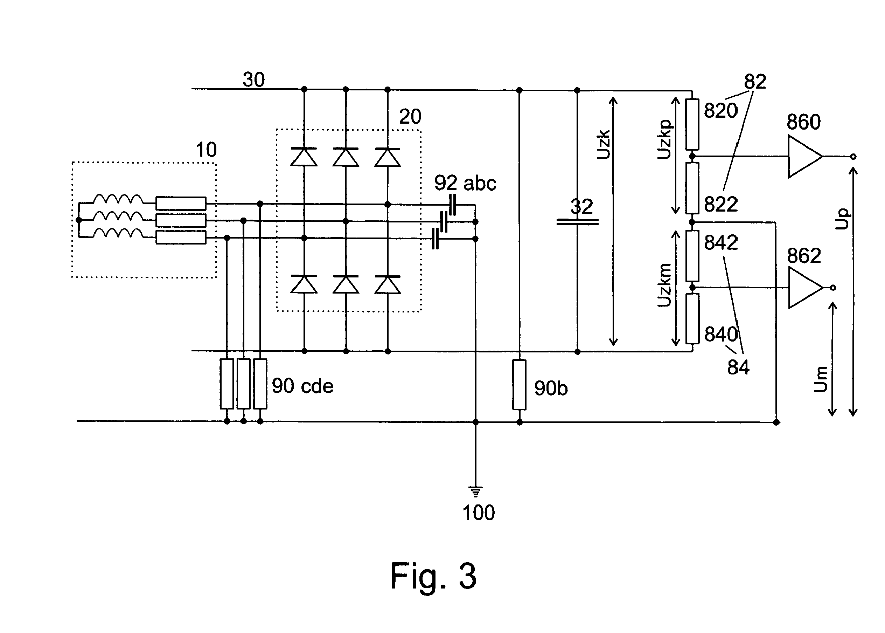

Fig. 3 zeigt weitere mögliche Varianten von Isolationsfehlern am Beispiel eines Generators (10) mit Gleichrichter (20) als Teil eines IT-Netzes. Dargestellt sind die internen Widerstände und Induktivitäten des Generators (10), sowie parasitäre Kondensatoren (92 a/b/c) in der Größenordnung von Zehntel Nanofarad, die im Betrieb des IT-Netzes zu dessen Impedanz gegen Grundpotential beitragen.

Die im betrachteten IT-Netz zu dessen Regelung bereits gemäß dem Stand der Technik enthaltene Messeinrichtungen (80, vgl. Fig. 1) ist ebenfalls dargestellt. Diese Messeinrichtung besteht aus einem ersten (82) und einem zweiten (84) Spannungsteiler. Diese Spannungsteiler sind symmetrisch ausgebildet und mit dem zugeordneten Zwischenkreispotential sowie mit dem Grundpotential verbunden. Über dem ersten Spannungsteiler (82) fällt somit ein erstes Potential (Uzkp) des Zwischenkreises (30) und über dem zweiten Spannungsteiler (84) das zweite Potential (Uzkm) ab. Die Spannungsteiler sind derart ausgebildet, dass der jeweils erste Widerstand (820, 840) von der Größenordnung (R1) Megaohm und der jeweils zweite Widerstand (822, 842) von der Größenordnung (R2) Kiloohm ist. Jeweils zwischen beiden Widerständen ist der Abgriff für die Messung des zugeordneten ersten (Up) bzw. zweiten (Um) Potentials gegen Grundpotential angeordnet.

Weiterhin dargestellt sind eine Mehrzahl von Widerständen (90 b/c/d/e), die verschiedene Isolationsfehler (Rf) repräsentieren, und einzeln oder auch in Gruppierungen auftreten können. Beispielhaft kann eine zeitlich langsame Veränderung der Isolation des IT-Netzes durch eine gleichmäßige Verringerung aller Widerstandswerte der Widerstände (90 c/d/e) beschrieben werden.

Eine Verringerung des Widerstandswerts (Rf) des Widerstands (90b) entspricht demgegenüber einer Verschlechterung der Isolation des ersten Potentials des Zwischenkreises (30).

Zur offline-Messung und Bestimmung des Isolationswiderstands mittels eines Mikrocontrollers, der Teil der beschriebenen Messeinrichtung (80) ist, werden alle ersten (52 a/b/c) oder alle zweiten (52 a/b/c) Schalter aller Stromrichter (vgl. Fig. 1 und 2) des betrachteten IT-Netzes geschlossen. Durch diese Beschaltung werden alle Leitungen des betrachteten IT-Netzes in ihrer Gesamtheit durch eine Messung auf ihren Isolationswiderstand hin geprüft und somit der Isolationswiderstand des gesamten IT-Netzes bestimmt. Für diese Messung sind ausschließlich Schaltungsteile einer Messeinrichtung (80) notwendig, die gemäß dem Stand der Technik ohnehin im betrachteten IT-Netz, das Ausgangspunkt dieser Erfindung war, enthalten sind.

Es ist besonders bevorzugt die beiden Teile der Messeinrichtung (80) symmetrisch zum Mittelpunkt mit Anschluss zum Grundpotential auszubilden, womit die Messung beispielhaft eines Isolationsfehlers (90a) wie in Fig. 2 dargestellt, folgendermaßen durchgeführt wird.

Die Zwischenkreisspannung (Uzk) lässt sich unabhängig vom Widerstandswert (Rf) des Isolationsfehlers folgendermaßen ausdrücken:

$$Uzk = (((R1 + R2) \bullet Up) / R2) + (((R1 + R2) \bullet Um) / R2)$$

mit

Uzk = Zwischenkreisspannung
R1 = Widerstandswert der Widerstände (820, 840)
R2 = Widerstandswert der Widerstände (822, 842)
Up = Potential gemessen mit der Messeinrichtung (860)
Um = Potential gemessen mit der Messeinrichtung (862)

Je kleiner der Widerstandswert (Rf) des Isolationsfehlers (90a) wird desto kleiner wird auch das Verhältnis aus Up und Uzk. Bei einem Erdschluss und somit einem minimalen Wert von Rf = 0 ist somit auch Up gleich Null. Umformen der obigen Gleichung und eliminieren von Um ergibt:
$$Up = Uzk \bullet (R2 / (R1 + R2)) \bullet (Rf / (R1 + R2 + 2 \bullet Rf))$$

mit R1 >> R2 lässt sich diese Gleichung vereinfachen zu:
$$Up = Uzk \bullet (R2 / R1) \bullet (1 / ((R1 / Rf) + 2)))$$

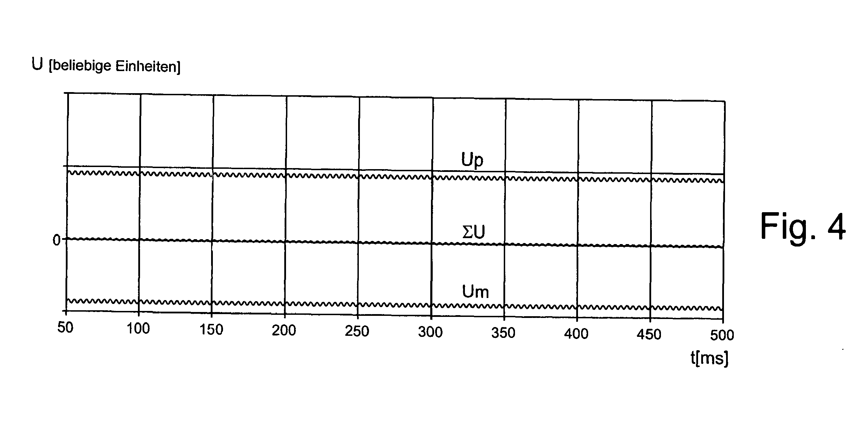

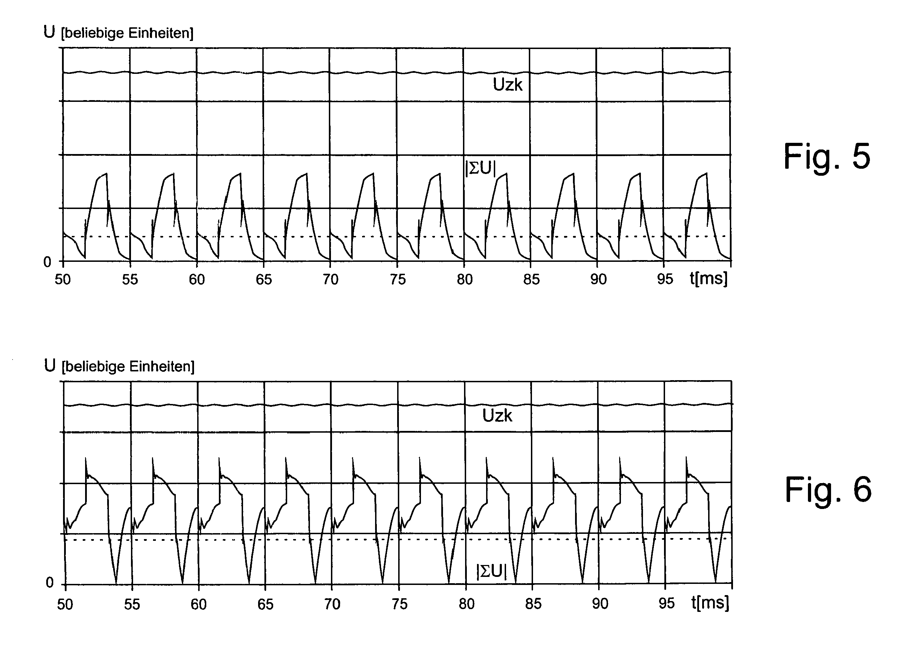

Wenn R2 / R1 nun so zweckmäßig gewählt wird, dass der Messbereich eines nachgeschalteten A/D- Wandlers vollständig ausgenutzt wird, ergibt sich bei einer Messgenauigkeit von 1 % und einer Messimpedanz von beispielhaft 1MΩ ein minimal zu detektierender Wert für Rf von der Größenordnung von 10kΩ. Diese Auflösung ist für die normgemäßen Anforderungen an eine Isolationsüberwachung ausreichend.
Zur Lokalisierung des Isolationsfehlers können einzelne erste oder zweite Schalter eingeschaltet werden, dann die beschriebene Messung wiederholt werden und somit der Bereich in dem der Isolationsfehler vorliegt bestimmt werden.
Die online-Messung erfolgt im Gegensatz zur oben beschrieben offline-Messung im Normalbetrieb des betrachteten IT-Netzes. Eine analytische Berechnung des Widerstandswerts (Rf) ist aufgrund der Variation und Komplexität beispielhaft der Impedanzen (92 a/b/c) im betrachteten IT-Netz nicht mittels eines Mikrocontrollers, wie er gemäß dem Stand der Technik Teil einer beschriebenen Messeinrichtung ist, praktikabel. Die erste Ausbildung des erfindungsgemäßen Verfahrens zur online-Messung wird beispielhaft anhand Fig. 3 und 4 beschrieben.
Im Idealfall eines IT-Netzes und bei einem Betrieb ohne Isolationsfehler sind zu jedem Betriebszeitpunkt die Potentiale Up und Um symmetrisch zum Grundpotential und daher ihre Beträge gleich. Bei einer Summenbildung ergibt sich daher der Wert (ΣU) von annährend Null (vgl. Fig. 4). Ein Isolationsfehler würde hierbei auf Grund einer Änderung eines Messwertes (Up oder Um) der zugeordneten Messeinrichtung (860 oder 862) den Wert (ΣU) der Summenbildung von der Nulllinie weg verschieben, und der Isolationsfehler (90b, vgl. Fig. 3) würde somit als solcher erkannt werden.
Eine Fouriertransformation des Summenwerts (ΣU) ergibt ohne Isolationsfehler unter Berücksichtigung aller Impedanzen ein Frequenzspektrum, welches als solches im Mikrocontroller berechnet und zum Vergleich mit Neuberechnungen gespeichert werden kann. Der Aufwand für die Speicherung der bereits durchgeführten Messungen wird vorteilhafterweise reduziert durch die Normierung der zu speichernden Werte mit der jeweils eingestellten Grundharmonischen der Wechselrichterausgangsspannung. Jeglicher unsymmetrisch über drei Phasen auftretende Isolationsfehler führt zu einer Änderung dieses Frequenzspektrums, der durch Vergleich mit dem gespeicherten Werten und durch geeignete Bewertung als solcher erkannt werden kann. Diese Änderungen des Frequenzspektrums können sowohl die auftretenden Frequenzen sowie auch deren Amplituden betreffen.
Eine vollständig symmetrische Veränderung des Isolationswiderstands aller drei Phasen, also einer symmetrischen Änderung des Widerstandswerts der Widerstände (90 c/d/e, vgl. Fig. 3) ist mit der hier beschriebenen ersten Ausbildung der online-Messung nicht möglich.
Die zweite Ausbildung des erfindungsgemäßen Verfahrens zur online-Messung wird beispielhaft anhand Fig. 3, 5 und 6 beschrieben. Hierbei werden die Messwerte der Potentialmessung addiert, von dem Summenwert (ΣU) der Betrag und hiervon der zeitliche Mittelwert geeignet gebildet und im Mikrocontroller gespeichert. Fig. 5 zeigt den Verlauf vor der Mittelwertbildung sowie den Mittelwert für den Fall, dass ein beliebiger der drei Widerstände (90 c/d/e) aus Fig. 3 einen beispielhaften Wert von 80kΩ aufweist. Im Vergleich dazu ist Fig. 6 der Verlauf dargestellt, wobei zwei beliebig der der drei Widerstände (90 c/d/e) aus Fig. 3 einen Wert von jeweils 160kΩ und somit die Isolation ebenfalls wie in Fig. 5 einen Gesamtwiderstand von 80kΩ aufweist.

Ein Vergleich der aktuellen Werte mit den im Mikrocontroller gespeicherten und eine geeignete Bewertung dieses Vergleichs führt wiederum zu einer Detektion eines Isolationsfehlers des IT-Netzes.

## Patentansprüche

1.  Verfahren zur Messung des Isolationswiderstands in einem IT-Netz, mit einem Gleichspannungszwischenkreis (30) und mindestens einem selbstgeführten Stromrichter (50 a/b) mit mindestens einem ersten (52 a/b/c) und einem zweiten Leistungsschalter (54 a/b/c), mit einer Messanordnung (80) zur Messung der Zwischenkreisspannung gegen Grundpotential (100) mit einem Spannungsteiler (82, 84) und zwei zugeordneten Potentialmesseinrichtungen (860, 862), bestehend aus einer offline- und einer online- Messung,
    wobei während der offline- Messung alle ersten (52 a/b/c) oder zweiten Leistungsschalter (54 a/b/c) geschlossen sind, die Potentiale Up bzw. Um sowie die Zwischenkreisspannung Uzk gemessen, und daraus der Isolationswiderstand Rf bestimmt wird,
    wobei während der online- Messung die beiden Potentiale Up und Um gemessen werden und der zeitliche Verlauf der Messungen geeignet bewertet wird.

2.  Verfahren nach Anspruch 1, wobei
    während der online- Messung die gemessenen beiden Potentiale summiert werden diese Summe Fourier transformiert wird und die Änderung des Frequenzspektrums in ihrem zeitlichen Verlauf bewertet wird.

3.  Verfahren nach Anspruch 1, wobei
    während der online- Messung die gemessenen beiden Potentiale summiert werden, der Betrag der Summe geeignet gemittelt wird und dieser Mittelwert in seinem zeitlichen Verlauf bewertet wird.

4.  Verfahren nach Anspruch 1, wobei
    während der offline- Messung der aus der vorhandenen parasitären Lastkapazität resultierende Einschwingvorgang der Potentialmessungen zur Funktionsüberprüfung der Isolationsmesseinrichtung verwendet wird.

5.  Verfahren nach Anspruch 1, wobei
    der Spannungsteiler (82, 84) symmetrisch ausgebildet ist.

6.  Verfahren nach Anspruch 1, wobei
    die Leistungsschalter (52 a/b/c, 54 a/b/c) als IGBTs (insulated gate bipolar transistor) mit antiparallel geschalteten Freilaufdioden (56) ausgebildet sind.

Fig. 1 *(Stand der Technik)*

Fig. 2

Fig. 3

EP 1 876 455 A1

EP 1 876 455 A1

U [beliebige Einheiten]

Fig. 4

Fig. 5

Fig. 6

EP 1 876 455 A1

**Europäisches
Patentamt**

**EUROPÄISCHER RECHERCHENBERICHT**

Nummer der Anmeldung

EP 07 01 2028

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 103 04 234 A1 (VOLKSWAGEN AG [DE]) 5. August 2004 (2004-08-05) * das ganze Dokument * ----- | 1,3-6 | INV. G01R31/02 G01R27/18 |
| A | DE 42 03 299 A1 (SIEMENS AG [DE]) 5. August 1993 (1993-08-05) * das ganze Dokument * ----- | 1,3-6 | |

**RECHERCHIERTE SACHGEBIETE (IPC)**

G01R
G01G

Der vorliegende Recherchenbericht wurde für alle Patentansprüche erstellt

| Recherchenort | Abschlußdatum der Recherche | Prüfer |
|---|---|---|
| Den Haag | 30. Oktober 2007 | Koll, Hermann |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
..............................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 07 01 2028

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-10-2007

| Im Recherchenbericht angeführtes Patentdokument | Datum der Veröffentlichung | Mitglied(er) der Patentfamilie | Datum der Veröffentlichung |
|---|---|---|---|
| DE 10304234 A1 | 05-08-2004 | KEINE | |
| DE 4203299 A1 | 05-08-1993 | KEINE | |

Für nähere Einzelheiten zu diesem Anhang : siehe Amtsblatt des Europäischen Patentamts, Nr.12/82

EPO FORM P0461

**EP 1 876 455 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0751396 B1